# EUROPÄISCHE PATENTSCHRIFT

(11) **EP 3 167 265 B1**
(45) Veröffentlichungstag und Bekanntmachung des Hinweises auf die Patenterteilung: **25.12.2019**
(21) Anmeldenummer: 15735673.4
(22) Anmeldetag: 06.07.2015
(51) Int. Cl.: G01C 19/5719, G01P 15/105, G01R 33/00, G01L 19/06, G01L 1/12, G01L 9/00, G01L 9/14, G01L 5/16, G01R 33/038, G01R 33/09

(54) **SENSOR**
SENSOR
CAPTEUR

(30) Priorität: 10.07.2014 DE 102014109701
(43) Veröffentlichungstag der Anmeldung: 17.05.2017
(73) Patentinhaber: TDK Electronics AG, 81671 München (DE)
(72) Erfinder: OSTRICK, Bernhard, 14513 Teltow (DE); SCHREIBER-PRILLWITZ, Wolfgang, 58730 Fröndenberg (DE)
(74) Vertreter: Epping - Hermann - Fischer
(86) Internationale Anmeldenummer: PCT/EP2015/065358
(87) Internationale Veröffentlichungsnummer: WO 2016/005325

(56) Entgegenhaltungen:
- EP-A1- 0 650 139
- EP-A2- 1 521 071
- DE-A1- 10 003 569
- US-A- 4 995 261
- US-A1- 2007 209 437
- US-A1- 2011 126 632
- US-A1- 2012 205 931

## Beschreibung

Die vorliegende Erfindung betrifft einen Sensor. Bei dem Sensor kann es in sich insbesondere um einen Sensor handeln, bei dem eine Messgröße auf Basis einer Auslenkung einer beweglichen Struktur zu einer starren Struktur bestimmt wird. Ein solches Messprinzip wird beispielsweise in Bewegungssensoren, Drucksensoren oder Drehratensensoren eingesetzt.

Bei vielen Anwendungen werden Sensoren zur Messung verschiedener Sensorgrößen miteinander kombiniert, wie zum Beispiel bei Inertialsensoren, die drei bis sechs Freiheitsgrade (degrees of freedom = DOF) bestimmen, und bei Bewegungssensoren, die sechs bis zehn Freiheitsgrade bestimmen. Weisen diese Sensoren voneinander unterschiedliche Signalwandlungsprinzipien auf, so kann dies zu einem erhöhten Aufwand im Systemdesign und der Signalverarbeitung führen. Es wäre daher wünschenswert, für unterschiedliche Sensortypen eine einheitliche Signalwandlung zu ermöglichen.

Ferner ist es auf Grund der fortschreitenden Miniaturisierung in vielen technischen Bereichen entscheidend auch Sensoren stets weiter zu miniaturisieren, ohne dass dabei die Messgenauigkeit leidet.

US 2012/205931 A1, US 2007/209437 A1, EP 0650139 A1, US 2011/126632 A1 und DE 10003569 A1 zeigen Sensoranordnungen. Dabei zeigt US 2012/205931 A1 einen Sensor mit einem Grundkörper, der ein starres Rahmenelement und ein relativ zum Rahmenelement bewegliches Betriebselement aufweist, wobei an dem Grundkörper ein Magnet und Hall-Elemente angeordnet sind. Die Hall-Elemente ermöglichen es, eine Kraftkomponente in drei Raumrichtungen und ein Drehmoment in drei Richtungen zu ermitteln. US 2007/209437 A1 beschreibt eine magnetische MEMS Vorrichtung, bei der magnetische Elemente dazu ausgebildet sind, ein magnetisches Feld zu emittieren oder zu detektieren. EP 0650139 A1 beschreibt eine Bedienplatte mit einer magnetischen Lage, die dazu ausgebildet ist, sich zu deformieren und sich den Konturen eines Objekts anzupassen, welches auf die Lage platziert wird. US 2011/126632 A1 beschreibt eine MEMS Sensor Vorrichtung aufweisend ein Substrat mit Sensoren. DE 10003569 A1 beschreibt einen Drucksensor mit einer Membran, auf welcher ein Signalgeber, beispielsweise ein Permanentmagnet, angeordnet ist, der relativ zu einem Hall-Element bewegt werden kann.

Weitere Sensoren sind aus EP 1521071 A2 und US 4,995,261 A bekannt.

Die Aufgabe der vorliegenden Erfindung ist es daher, einen verbesserten Sensor anzugeben, der zumindest einen der oben genannten Vorteile bietet.

Diese Aufgabe wird durch eine Sensoranordnung gemäß dem vorliegenden Anspruch 1 gelöst.

Es wird eine Sensoranordnung vorgeschlagen, die einen ersten Sensor, der eine Beschleunigung mit drei Freiheitsgraden bestimmt,- einen zweiten Sensor, der eine Drehrate mit drei Freiheitsgraden bestimmt,- einen dritten Sensor, der eine Ausrichtung auf dem Erdmagnetfeld mit drei Freiheitsgraden bestimmt, und- einen vierten Sensor, der eine Höhe mittels einer Druckmessung bestimmt, aufweist, wobei der erste Sensor, der zweite Sensor und der vierte Sensor jeweils ein magnetsensitives Element und einen Magneten aufweisen, von denen ein Element auf einer beweglichen Struktur und das andere auf einer starren Struktur angeordnet ist, wobei eine Relativposition der beweglichen Struktur zu der zugehörigen starren Struktur jeweils durch eine Bestimmung des Magnetfeldes an der Position des zugehörigen magnetsensitiven Elements bestimmt wird, und wobei der dritte Sensor ein magnetsensitives Element aufweist und das Erdmagnetfeld mittels des magnetsensitiven Elements bestimmt wird.

Bei dem Sensor kann es sich um ein Mikrobauelement handeln, insbesondere um ein MEMS-Bauelement (MEMS = Mikroelektromechanisches System). Der Sensor kann beispielsweise ein Drucksensor, ein Beschleunigungssensor oder ein Drehratensensor sein. Der Sensor kann auch in einem Mikrofon zur Umwandlung von Schallwellen in ein elektrisches Signal eingesetzt werden, wobei die Schallwellen eine als Membran ausgestaltete bewegliche Struktur auslenken.

Indem entweder der Magnet oder das magnetsensitive Element auf der beweglichen Struktur befestigt ist und ferner das jeweils andere Element auf der starren Struktur befestigt ist, kann aus der relativen Position des Magneten und des magnetsensitiven Elementes auf die relative Position der beweglichen Struktur zu der starren Struktur zurückgeschlossen werden. Insbesondere können der Magnet und das erste magnetsensitive Element derart mit der beweglichen Struktur und der starren Struktur verbunden sein, dass eine Bewegung der beweglichen Struktur relativ zu der starren Struktur zu einer entsprechenden Relativbewegung des Magneten zu dem ersten magnetsensitiven Element führt. Dementsprechend wird sich das Magnetfeld am Ort des ersten magnetsensitiven Elements abhängig von der Relativposition der beweglichen Struktur zu der starren Struktur ändern.

Diese Ausgestaltung des Sensors bietet eine große Designfreiheit hinsichtlich der Positionierung des magnetsensitiven Elements und des Magneten.

Bei kapazitiven Sensoren hängen die Sensitivität und das Signal-zu-Rausch-Verhältnis stark von der Größe der kapazitiven Struktur ab. Ein kapazitiver Sensor mit einer hohen Messgenauigkeit erfordert daher eine bestimmte Mindestgröße. Diesen Nachteil überwindet der vorliegende Sensor, da das magnetsensitive Element und der Magnet sehr klein sein können, ohne dass dabei die Messgenauigkeit abnimmt. Der vorliegende Sensor kann also eine sehr hohen Miniaturisierungsgrad und dementsprechend nur einen sehr geringen Platzbedarf aufweisen.

Das magnetsensitive Element kann dazu ausgestaltet sein, die Feldstärke des Magnetfeldes und/oder die Feldrichtung des Magnetfeldes an seiner Position zu bestimmen. Dazu kann das magnetsensitive Element beispielsweise den Hall-Effekt oder einen magnetoresistiven Effekt ausnutzen.

Als magnetoresistiven Effekt bezeichnet man alle Effekte, die die Änderung eines elektrischen Widerstands eines Materials durch Anlegen eines äußeren Magnetfeldes beschreiben. Hierzu gehören insbesondere der anisotrope magnetoresistive Effekt (AMR-Effekt), der Riesenmagnetowiderstand (GMR-Effekt), der kolossale magnetoresistive Effekt (CMR-Effekt), der magnetische Tunnelwiderstand (TMR-Effekt) sowie der planare Hall-Effekt. Unter Nutzung dieser magnetoresistiven Effekte kann das magnetsensitive Element die magnetische Feldstärke und/oder die magnetische Feldrichtung an seiner Position ermitteln.

Der Sensor kann dazu ausgestaltet sein, die relative Position der beweglichen Struktur zu der starren Struktur durch die Bestimmung des Magnetfeldes an der Position des magnetsensitiven Elements zu ermitteln. Dieses Messprinzip weist den großen Vorteil auf, dass es sich für jegliche Art von Sensoren anwenden lässt, bei denen eine bewegliche Struktur relativ zu einer starren Struktur bewegt wird. Das Messprinzip kann beispielsweise bei Sensoren zur Messung von Druck, Bewegung, Beschleunigung oder Drehraten angewendet werden.

Jeder dieser Sensoren, der das oben beschriebene Messprinzip verwendet, kann ferner mit dergleichen Signalverarbeitung kombiniert werden. Da dieses Messprinzip für unterschiedliche Sensoren anwendbar ist, ermöglicht das Messprinzip, für unterschiedliche Sensoren ein einheitliches Signalwandlungsprinzip zu verwenden.

Auch Sensoren, die eine absolute Position auf Basis einer Messung des Erdmagnetfeldes bestimmen, weisen ein magnetsensitives Element auf, so dass auch für diese Art von Sensoren die gleiche Schaltung zur Signalverarbeitung eingesetzt werden kann.

Der Sensor kann zumindest ein zweites magnetsensitives Element aufweisen, das dazu ausgestaltet ist, an seiner Position das Magnetfeld zu bestimmen. Durch die Anwendung zumindest zweier magnetsensitiver Elemente kann die Position der beweglichen Struktur relativ zu der starren Struktur eindeutig bestimmt werden. Bei einer entsprechend geschickten Anordnung der beiden magnetsensitiven Elemente und des Magneten kann die relative Position in allen drei Raumrichtungen ermittelt werden. In alternativen Ausführungsbeispielen kann die relative Position zumindest in zwei Raumrichtungen eindeutig bestimmt werden.

Insbesondere können das erste und das zweite magnetsensitive Element entweder beide auf der beweglichen Struktur befestigt sein oder beide auf der starren Struktur befestigt sein. Der Magnet kann dann auf der jeweils anderen Struktur befestigt sein. Dabei kann aus der relativen Position des Magneten und der beiden magnetsensitiven Elemente auf die relative Position der beweglichen Struktur zu der starren Struktur zurückgeschlossen werden. Insbesondere können der Magnet und die beiden magnetsensitiven Element derart mit der beweglichen Struktur und der starren Struktur verbunden sein, dass eine Bewegung der beweglichen Struktur relativ zu der starren Struktur zu einer entsprechenden Relativbewegung des Magneten zu den beiden magnetsensitiven Element führt. Dementsprechend werden sich das Magnetfeld am Ort des ersten magnetsensitiven Elements sowie das Magnetfeld am Ort des zweiten magnetsensitiven Elements abhängig von der Relativposition der beweglichen Struktur zu der starren Struktur ändern.

In manchen Ausgestaltungen weist der Sensor vier magnetsensitive Elemente auf. Diese können mittels einer Wheatstoneschen Messbrücke verschaltet werden, wodurch die Auslesung und Auswertung der von den Strukturen gemessenen Daten besonders einfach vorgenommen werden kann. Die vier magnetsensitiven Elemente können entweder auf der beweglichen Struktur oder auf der starren Struktur angeordnet sein.

Das erste und das zweite magnetsensitive Element können in einer Ebene angeordnet sein. Dabei können die beiden magnetsensitiven Elemente entweder beide auf der starren Struktur oder beide auf der beweglichen Struktur angeordnet sein. Die Ebene kann insbesondere parallel zu einer Ebene sein, in der sich die bewegliche Struktur in ihrem nicht ausgelenkten Zustand erstreckt. Handelt es sich bei der beweglichen Struktur etwa um eine Membran, so liegt die Membran in einem Zustand, in dem die Membran nicht ausgelenkt ist, in einer Ebene, wobei das erste und das zweite magnetsensitive Element entweder in derselben Ebene wie die Membran angeordnet sein können oder in einer Ebene liegen können, die parallel zu der von der Membran definierten Ebene ist.

In der Ebene können neben dem ersten und dem zweiten magnetsensitiven Elemente weitere magnetsensitive Elemente angeordnet sein. Die Anordnung des ersten und des zweiten magnetsensitiven Elementes in der Ebene ermöglicht es, zumindest die Position der beweglichen Struktur innerhalb der Ebene genau zu bestimmen.

Ferner kann der Magnet außerhalb der Ebene angeordnet sein, wenn sich die bewegliche Struktur in einem unausgelenkten Zustand befindet. In diesem Fall kann der Sensor die Position der beweglichen Struktur in allen drei Raumrichtungen eindeutig ermitteln.

Der Sensor kann ferner einen Anschlag aufweisen, der die Bewegungsmöglichkeiten der beweglichen Struktur derart begrenzt, dass der Magnet sich stets auf einer ersten Seite der Ebene oder in der Ebene befindet. Alternativ zu dem Anschlag kann der Sensor auch eine anders ausgestaltet Struktur aufweisen, die die Bewegungsmöglichkeiten der beweglichen Struktur derart begrenzt, dass der Magnet sich stets auf einer ersten Seite der Ebene oder in der Ebene befindet.

Auf diese Weise kann verhindert werden, dass der Magnet sich auf eine zweite Seite der Ebene bewegt. Somit kann es nicht zu Zweideutigkeiten bei der Positionsbestimmung kommen. Bei der ersten Seite kann es sich um eine Oberseite oder eine Unterseite der Ebene handeln. Die Oberseite der Ebene ist dadurch definiert, dass auf dieser Seite der Magnet oder die magnetsensitiven Elemente auf der beweglichen Struktur angeordnet sind. Ferner kann die Unterseite der Ebene der Seite der beweglichen Struktur entsprechen, die frei von den magnetsensitiven Elementen oder dem Magneten ist.

Ferner kann der Sensor ein weiteres magnetsensitives Element aufweisen, das dazu ausgestaltet ist, an seiner jeweiligen Position das Magnetfeld zu bestimmen, wobei das weitere magnetsensitive Element außerhalb der Ebene angeordnet ist, in der das erste und das zweite magnetsensitive Element angeordnet sind. Auf diese Weise kann die Position der beweglichen Struktur relativ zu der starren Struktur in allen drei Raumrichtungen eindeutig bestimmt werden, ohne dass eine Begrenzung der Bewegungsmöglichkeiten der beweglichen Struktur erforderlich ist. Dementsprechend kann ein größerer Messbereich abgedeckt werden.

Bei der beweglichen Struktur kann es sich beispielsweise um eine Membran oder um eine seismische Masse handeln. Die Membran kann beispielsweise relativ zu einem Rahmen, der die Membran in einer Ebene umschließt, bewegt werden, wobei der Rahmen die starre Struktur bildet. Die seismische Masse kann aus Siliziummikrostrukturen gebildet sein.

Der Sensor kann dazu ausgestaltet sein, die bewegliche Struktur zu Schwingungen anzuregen. Wird die bewegliche Struktur zu Schwingungen angeregt, so können mit Hilfe des Sensors Drehraten gemessen werden.

Es sind verschiedene Arten der Anregung von Schwingungen der beweglichen Struktur denkbar. Die bewegliche Struktur kann eine seismische Masse sein, die an einem Balken aufgehängt ist, wobei die seismische Masse Biege- und/oder Torsionsschwingungen ausführen kann. Die bewegliche Struktur kann als eine Elektrode ausgebildet sein oder mit Elektrodenstrukturen verbunden sein und über die Elektrodenstrukturen elektrostatisch zu Schwingungen angeregt werden. Die bewegliche Struktur kann als eine Elektrode ausgebildet sein oder Elektrodenstrukturen aufweisen und ferner einen piezoelektrischen Film aufweisen und mit Hilfe der Elektrodenstrukturen und des piezoelektrischen Films zu Schwingungen angeregt werden.

Der Magnet kann ein strukturierter Dünnfilmpermanentmagnet sein. Der Magnet kann eine Länge und eine Breite aufweisen, wobei das Verhältnis von Länge zu Breite ungleich eins ist. Dieses Verhältnis wird auch als Aspektverhältnis des Magneten bezeichnet. Dementsprechend kann der Magnet stabförmig oder ellipsenförmig ausgebildet sein. Ein solcher Magnet erzeugt ein Magnetfeld das einen geringeren Symmetriegrad aufweist als das Magnetfeld eines Magneten mit einem Aspektverhältnis von eins, so dass die Bestimmung der Position des magnetsensitiven Elements relativ zu dem Magneten einfacher vorzunehmen ist.

Der Magnet kann eine stromdurchflossene Spule aufweisen. Dementsprechend kann es sich um einen Elektromagneten handeln, der ein- und ausschaltbar ist.

Ferner kann der Sensor eine zweite bewegliche Struktur aufweisen, die relativ zu der starren Struktur bewegbar ist. Der Sensor kann ferner einen weiteren Magneten, der ein weiteres Magnetfeld erzeugt, und ein zusätzliches magnetsensitives Element, das dazu ausgestaltet ist, an seiner Position das weitere Magnetfeld zu bestimmen, aufweisen. Entweder können der weitere Magnet an der starren Struktur und das zusätzliche magnetsensitive Element an der zweiten beweglichen Struktur befestigt sein oder der weitere Magnet kann an der zweiten beweglichen Struktur und das zusätzliche magnetsensitive Element an der starren Struktur befestigt sein.

Auf diese Weise können somit zwei bewegliche Strukturen miteinander kombiniert werden, was es ermöglicht, mehrere Messgrößen gleichzeitig zu ermitteln. Beispielsweise kann mittels der ersten beweglichen Struktur, des ersten magnetsensitiven Elements und des ersten Magneten eine Beschleunigung gemessen werden und mittels der zweiten beweglichen Struktur, des zusätzlichen magnetsensitiven Elements und des weiteren Magneten eine Drehrate.

An der zweiten beweglichen Struktur können darüber hinaus noch mehr magnetsensitive Elemente befestigt werden. Für die zweite bewegliche Struktur und die starre Struktur sind insbesondere sämtliche Ausführungsformen möglich, die hier im Zusammenhang mit der ersten beweglichen Struktur und der starren Struktur offenbart sind, möglich.

Auch eine Höhe oder eine absolute Position kann mit einem Sensor bestimmt werden, bei dem eine relative Position eines Magneten und eines magnetsensitiven Elementes bestimmt wird.

Da sämtliche auf diese Weise ermittelten Freiheitsgrade jeweils durch die relative Position eines Magneten zu einem magnetsensitiven Element bestimmt werden, kann eine einheitliche Ausleseelektronik verwendet werden. Somit kann die anschließende Signalverarbeitung vereinfacht werden. Insbesondere können dieselben Signalpfade für sämtliche Messgrößen verwendet werden. Dadurch wird der Aufwand für das Design eines ASIC (application specific integrated circuit) reduziert. Ferner wird auch ein Funktionstest des ASIC deutlich vereinfacht.

Eine Elektrodenstruktur kann an der starren Struktur und an der zweiten beweglichen Struktur ausgebildet sein und dazu ausgestaltet sein, die zweite bewegliche Struktur zu Schwingungen anzuregen. Dabei kann entweder die starre Struktur und die zweite bewegliche Struktur aus einem leitenden Material bestehen und so die Elektrodenstruktur selbst ausbilden oder eine Elektrodenstruktur kann jeweils auf der starren Struktur und aus der zweiten beweglichen Struktur angebracht sein.

Dementsprechend kann die zweite bewegliche Struktur zur Messung einer Drehrate verwendet werden. Die erste bewegliche Struktur kann zur Messung einer Bewegung verwendet werden. Damit ergibt sich ein Sensor, der zur Bestimmung von sechs Freiheitsgraden geeignet ist.

Ferner kann der Sensor Strukturen zur Messung der Richtung des Erdmagnetfeldes und/oder Strukturen zur Messung eines Druckes aufweisen. Durch die Bestimmung des Erdmagnetfeldes lässt sich eine absolute Position bestimmen. Alternativ oder ergänzend kann durch die Bestimmung des Erdmagnetfeldes eine Ausrichtung auf dem Erdmagnetfeld ermittelt werden, die zur Bestimmung einer Ausrichtung des Sensors, des sogenannten Headings, verwendet werden kann. Damit kann der Sensor drei weitere Freiheitsgrade ermitteln. Durch die Messung des Druckes kann die Höhe bestimmt werden, sodass der Sensor einen weiteren Freiheitsgrad ermitteln kann. Der hier beschriebene Sensor kann also insgesamt zehn Freiheitsgrade bestimmen. Sämtliche dieser Freiheitsgrade können durch die relative Position eines Magneten zu einem magnetsensitiven Element ermittelt werden, wobei entweder der Magnet oder das magnetsensitive Element auf einer starren Struktur und das jeweils andere Element ausgewählt aus dem Magnet und dem magnetsensitivem Element auf der beweglichen Struktur angeordnet sind. Somit können zur Bestimmung jedes Freiheitsgrades identische Signalverarbeitungen verwendet werden.

Ferner kann das Erdmagnetfeld eine Störung für die Messungen von Interialsensor und Drehratensensor darstellen. Wird es separat vermessen, so kann diese Störung korrigiert werden und so Genauigkeit der übrigen Messungen erhöht werden.

Ferner können mehrere der oben beschriebenen Sensoren zu einer Sensoranordnung kombiniert werden. Beispielsweise können zumindest zwei der folgenden Sensoren miteinander kombiniert werden ausgewählt aus einem erster Sensor, der eine Beschleunigung mit drei Freiheitsgraden bestimmt, einem zweiten Sensor, der eine Drehrate mit drei Freiheitsgraden bestimmt, einem dritten Sensor, der das Erdmagnetfeld mit drei Freiheitsgraden bestimmt, und einem vierten Sensor, der eine Höhe mittels einer Druckmessung bestimmt. Jeder dieser Sensoren kann ein magnetsensitives Element aufweisen. Insbesondere können der erste, zweite und vierte Sensor ein magnetsensitives Element und einen Magneten aufweisen, von denen ein Element auf einer beweglichen Struktur und das andere auf einer starren Struktur angeordnet ist. Der dritte Sensor kann ebenfalls ein magnetsensitives Element aufweisen.

Ferner können bei dieser Sensoranordnung bis zu sieben unterschiedliche bewegliche Strukturen sowie drei statische Strukturen zur Messung des Erdmagnetfeldes miteinander kombiniert werden und beispielsweise auf einem einzigen Chip integriert werden. Insbesondere können drei der sieben beweglichen Strukturen dabei je eine Koordinate einer Beschleunigung messen, drei weitere Strukturen der sieben beweglichen Strukturen können dabei je eine Koordinate einer Drehrate messen, die siebte bewegliche Struktur kann einen Druck und damit eine Höhe messen und die drei statischen Strukturen können das Erdmagnetfeld und damit eine absolute Position messen.

Da die Relativposition der beweglichen Strukturen zu einer zugehörigen starren Struktur jeweils mittels eines magnetsensitiven Elementes bestimmt werden kann und auch das Erdmagnetfeld mittels magnetsensitiver Elemente bestimmt wird, kann der Chip mit einer einheitlichen Ausleseelektronik kombiniert werden, die für alle Sensoren das gleiche Signalwandlungsprinzip verwendet.

Ferner kann die Anzahl der beweglichen Strukturen reduziert werden, indem die Auslenkung einer beweglichen Struktur in verschiedene Raumrichtungen durch mehrere magnetsensitive Elemente erfasst wird. Auf diese Weise ist eine weitere Miniaturisierung möglich.

In einer Ausführungsform kann die bewegliche Struktur sich in einem nicht ausgelenkten Zustand in einer Ebene erstreckt, wobei eines ausgewählt aus dem magnetsensitiven Element und dem Magneten in der Ebene angeordnet ist und das andere ausgewählt aus dem magnetsensitiven Element und dem Magneten außerhalb der Ebene angeordnet ist. Als nicht ausgelenkter Zustand kann dabei ein Zustand bezeichnet werden, bei dem keine Kraft auf die bewegliche Struktur einwirkt. Der nicht ausgelenkte Zustand kann ein Ruhezustand der beweglichen Struktur sein.

Im Folgenden wird die vorliegende Erfindung anhand von Figuren genauer beschrieben.
- Figur 1: zeigt ein erstes Ausführungsbeispiel eines Sensors.
- Figur 2: zeigt ein zweites Ausführungsbeispiel eines Sensors.
- Figur 3: zeigt ein drittes Ausführungsbeispiel eines Sensors.
- Figur 4: zeigt ein viertes Ausführungsbeispiel eines Sensors.
- Figur 5: zeigt ein fünftes Ausführungsbeispiel eines Sensors.
- Figur 6: zeigt ein sechstes Ausführungsbeispiel eines Sensors.
- Figur 7: zeigt ein siebtes Ausführungsbeispiel eines Sensors.

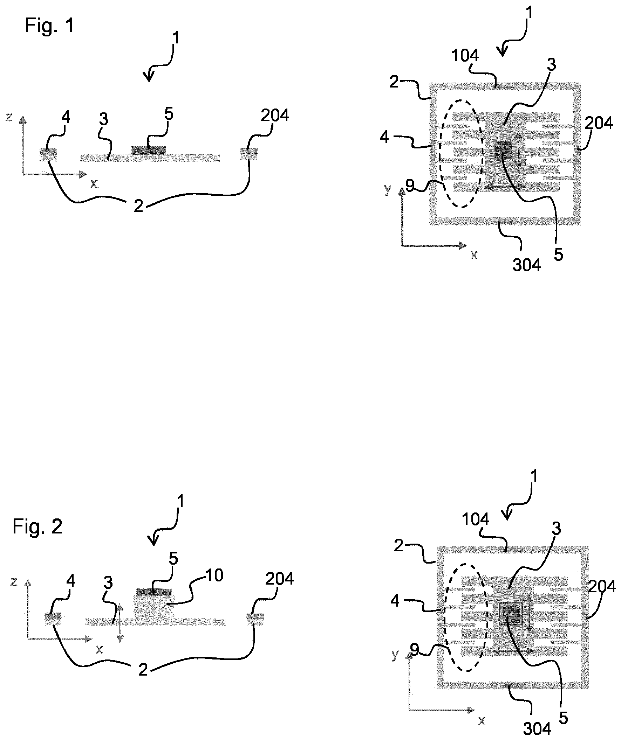

Figur 1 zeigt einen Sensor 1. Der Sensor 1 weist eine starre Struktur 2 und eine bewegliche Struktur 3 auf, die relativ zu der starren Struktur 2 bewegbar ist.

Der Sensor 1 ist dazu ausgestaltet, eine Bewegung der beweglichen Struktur 3 relativ zu der starren Struktur 2 zu messen. Dieses Sensorkonzept wird beispielsweise in Drucksensoren verwendet, bei denen die Auslenkung einer Membran relativ zu einem Rahmen gemessen wird. Dementsprechend kann es sich bei der beweglichen Struktur 3 um die Membran und bei der starren Struktur 2 um den Rahmen handeln. Auch andere Sensoren, wie beispielsweise Sensoren zur Messung von Beschleunigungen oder Sensoren zur Messung von Drehraten, basieren auf der Messung der Auslenkung einer beweglichen Struktur 3 relativ zu einer starren Struktur 2. Bei der beweglichen Struktur 3 kann es sich um eine seismische Masse handeln.

In dem in Figur 1 dargestellten Ausführungsbeispiel ist die bewegliche Struktur 3 eine Membran. Ferner ist die starre Struktur 2 ein Rahmen.

Es handelt sich bei dem in Figur 1 gezeigten Sensor 1 um einen Inertialsensor zur Messung von Beschleunigungen. Die bewegliche Struktur 3 ist derart an der starren Struktur 2 befestigt, dass sie sich relativ zu der starren Struktur 2 in jede Raumrichtung bewegen kann. Zu diesem Zweck ist die bewegliche Struktur 3 mit Federelementen (nicht gezeigt) an der starren Struktur 2 aufgehängt.

Ferner weist der in Figur 1 gezeigte Sensor 1 ein erstes magnetsensitives Element 4 und einen Magneten 5 auf. Der Magnet 5 ist dazu ausgestaltet, ein Magnetfeld zu erzeugen. Bei dem Magneten 5 kann es sich um einen Permanentmagneten handeln, der stets ein Magnetfeld erzeugt. Insbesondere kann es sich bei dem Magneten 5 um einen strukturierten Dünnfilm Permanentmagneten handeln. Der Magnet 5 weist ein Aspektverhältnis auf, das ungleich eins ist. Das Aspektverhältnis ist definiert ist als Verhältnis der Länge des Magneten 5 zu seiner Breite. Dementsprechend kann der Magnet 5 beispielsweise stabförmig oder ellipsenförmig ausgebildet sein.

Alternativ kann es sich bei dem Magneten 5 um einen Elektromagneten handeln, der nur dann ein Magnetfeld erzeugt, wenn er eingeschaltet ist. Dementsprechend kann der Magnet 5 eine stromdurchflossene Spule aufweisen.

Das erste magnetsensitive Element 4 ist dazu ausgestaltet, an seiner Position das Magnetfeld zu bestimmen. Bei dem magnetsensitiven Element 4 kann es sich beispielsweise um ein Hall-Element handeln, das auf Basis des Hall-Effektes die Feldstärke des Magnetfeldes bestimmt. Alternativ oder ergänzend kann das magnetsensitive Element 4 das Magnetfeld mit Hilfe des magnetoresistiven Effektes bestimmen.

Anhand dieser Informationen kann die relative Position des magnetsensitiven Elementes 4 zu dem Magneten 5 bestimmt werden.

Bei dem in Figur 1 gezeigten Ausführungsbeispiel ist der Magnet 5 unmittelbar auf der beweglichen Struktur 3 befestigt und das magnetsensitive Element 4 ist unmittelbar auf der starren Struktur 2 befestigt. Insbesondere kann sich der Magnet 5 nicht relativ zu der beweglichen Struktur 3 bewegen und das magnetsensitive Element 4 kann sich nicht relativ zu der starren Struktur 2 bewegen.

Figur 1 zeigt in der linken Abbildung einen Querschnitt durch den Sensor 1 in der xz-Ebene. In der rechten Abbildung 1 ist ein Querschnitt durch den Sensor 1 in der xy-Ebene gezeigt. Die z-Richtung ist als Richtung der Flächennormale der beweglichen Struktur 3 definiert. Die x- und die y-Richtung sind jeweils senkrecht zur z-Richtung und senkrecht zueinander.

Figur 1 zeigt den Sensor 1 in einem Zustand, in dem sich die bewegliche Struktur 3 in einem unausgelenkten Zustand befindet. In diesem Zustand wirkt keine externe Kraft auf die bewegliche Struktur 3. Wird ein Druck auf die bewegliche Struktur 3 ausgeübt, beispielsweise durch Schallwellen, so wird die bewegliche Struktur 3 relativ zu der starren Struktur 2 ausgelenkt.

Ferner weist der Sensor 1 neben dem ersten magnetsensitiven Element 4 ein zweites, ein drittes und ein viertes magnetsensitives Element 104, 204, 304 auf. Die vier magnetsensitiven Elemente 4, 104, 204, 304 sind an der starren Struktur 2 befestigt. Die vier magnetsensitiven Elemente 4, 104, 204, 304 sind in einer Ebene angeordnet. In dem unausgelenkten Zustand der beweglichen Struktur 3 ist ferner auch der Magnet 5 in der Ebene angeordnet. Der Sensor 1 ermöglicht eine eindeutige Bestimmung der Position der beweglichen Struktur 3 innerhalb der Ebene, die auch als xy-Ebene bezeichnet wird.

Bewegt sich die bewegliche Struktur 3 in eine Richtung senkrecht zu der xy-Ebene, so ermöglicht der Sensor 1 keine eindeutige Bestimmung der z-Position der beweglichen Struktur 3. Insbesondere kann nicht unterschieden werden, ob sich die bewegliche Struktur 3 in positive z-Richtung oder in negative z-Richtung bewegt. Als positive z-Richtung wird hier die Richtung von der Unterseite der beweglichen Struktur 3 zur Oberseite der beweglichen Struktur 3 bezeichnet, wobei der Magnet 5 auf der Oberseite der beweglichen Struktur 3 angeordnet ist und die Unterseite der beweglichen Struktur 3 frei von dem Magneten 5 ist. Die negative z-Richtung ist zur positiven z-Richtung entgegengesetzt.

Ferner ist zwischen der beweglichen Struktur 3 und der starren Struktur 2 eine Kammstruktur 9 ausgebildet. Im Bereich dieser Kammstruktur 9 können an der beweglichen Struktur 3 und an der starren Struktur 2 jeweils Elektroden ausbilden. Insbesondere können die bewegliche Struktur 3 und die starre Struktur 2 jeweils aus einem leitenden Material bestehen, so dass an ihnen jeweils eine Spannung angelegt wird. Über diese Elektroden kann die bewegliche Struktur 3 elektrostatisch zu Schwingungen angeregt werden. Alternativ ist es auch möglich, die bewegliche Struktur 3 mit einer Elektrodenstruktur und einem piezoelektrischen Film zu versehen und über den piezoelektrischen Film zu Schwingungen anzuregen. Bei Drehratensensoren wird die bewegliche Struktur 3 in Schwingungen versetzt, um die Drehraten zu bestimmen.

Ferner ist es denkbar, dass im Bereich der Kammstruktur 9 die bewegliche Struktur 3 und die starren Struktur 2 jeweils Elektroden ausbilden und der Sensor 1 in einem elektrostatischen Close-Loop-Verfahren betrieben wird. Dabei wird zunächst eine Bewegung der beweglichen Struktur 3 erfasst und anschließend an den Elektroden ein Gegenfeld angelegt, das die bewegliche Struktur 3 in Ruhe hält. Diese Close-Loop-Messung ermöglicht es, das dynamische Verhalten des Sensors 1 weiter zu verbessern. Es handelt sich bei der Kammstruktur 9 und den in diesem Zusammenhang genannten Ausführungsformen um optionale Ausgestaltungen, die nicht zwangsläufig für die Funktionsweise des Sensors 1 erforderlich sind, die jedoch bei bestimmten Anwendungen vorteilhaft sein können.

Der in Figur 1 gezeigte Sensor 1 weist vier magnetsensitive Elemente 4, 104, 204, 304 auf, die über eine Wheatstonesche Messbrücke miteinander verschaltet werden und so zur Messung der Position der beweglichen Struktur 3 verwendet werden. Die Verschaltung mittels der Wheatstoneschen Messbrücke bietet die Vorteile, dass eine eindeutige Messung mit einer einfachen Verschaltung möglich ist und dass ferner eine hohe Messgenauigkeit erreicht wird. Bei der Wheatstoneschen Messbrücke handelt es sich um ein Standardausleseverfahren, das mit zahlreichen Auswerteschaltungen kombinierbar ist.

Eine eindeutige Bestimmung der xy-Position der beweglichen Struktur 3 kann bereits mit zwei magnetsensitiven Elementen 4, 104 erreicht werden. Dementsprechend könnte der Sensor 1 in einer alternativen Ausgestaltung lediglich das erste und das zweite magnetsensitive Element 4, 104 aufweisen.

Figur 2 zeigt ein zweites Ausführungsbeispiel des Sensors 1. In der linken Abbildung ist ein Querschnitt durch den Sensor 1 in der xz-Ebene gezeigt und in der rechten Abbildung ist ein Querschnitt durch den Sensor 1 in der xy-Ebene dargestellt.

Der in Figur 2 gezeigte Sensor 1 unterscheidet sich von dem in Figur 1 gezeigten Sensor 1 dadurch, dass der Magnet 5 in einem unausgelenkten Zustand der beweglichen Struktur 3 außerhalb der Ebene angeordnet ist, in der die vier magnetsensitiven Elemente 4, 104, 204, 304 angeordnet sind. Dadurch kann der in Figur 2 dargestellte Sensor 1 eine eindeutige Messung der x-, y- und z-Koordinate der Position der beweglichen Struktur 3 vornehmen. Insbesondere weist die bewegliche Struktur 3 auf ihrer Oberseite eine Erhöhung 10 auf, auf der der Magnet 5 angeordnet ist. Der Sensor 1 ermöglicht eine eindeutige Bestimmung der Position der beweglichen Struktur 3 relative zur starren Struktur 2 in z-Richtung, sofern der Magnet 5 sich nicht so weit in die negative z-Richtung bewegt, dass er sich unterhalb der von den magnetsensitiven Elementen 4, 104, 204, 304 aufgespannten Ebene befindet. In diesem Fall würde es zu einem zweideutigen Messergebnis kommen.

Der in Figur 2 dargestellte Sensor 1 weist die gleiche Anzahl an magnetsensitiven Elementen 4, 104, 204, 304 und Magneten 5 auf wie der in Figur 1 dargestellte Sensor 1 und ermöglicht es ferner zusätzlich die z-Koordinate der Position der beweglichen Struktur 3 zu bestimmen.

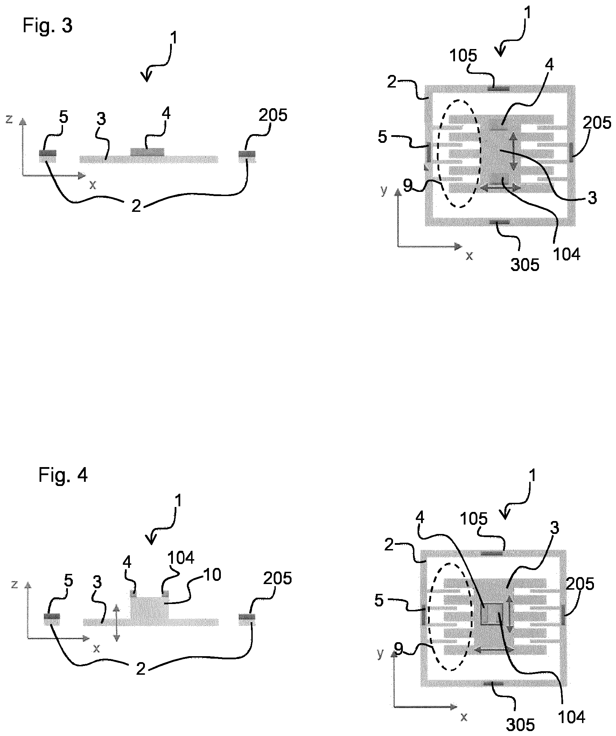

Figur 3 zeigt ein drittes Ausführungsbeispiel des Sensors 1. In der linken Abbildung ist ein Querschnitt durch die xz-Ebene dargestellt und in der rechten Abbildung ist ein Querschnitt durch die xy-Ebene dargestellt.

Gegenüber dem in Figur 1 dargestellten ersten Ausführungsbeispiel wurden die magnetsensitiven Elemente 4, 104, 204, 304 durch Magnete 5, 105, 205, 305 ersetzt. Ferner wurde der Magnet 5 durch zwei magnetsensitive Elemente 4, 104 ersetzt. Dementsprechend sind nunmehr Magnete 5, 105, 205, 305 auf der starren Struktur 2 angeordnet. Insbesondere weist der Sensor 1 vier Magnete 5, 105, 205, 305 auf, die jeweils auf der starren Struktur 2 angeordnet sind, und sich nicht relativ zu der starren Struktur 2 bewegen können. Ferner sind zwei magnetsensitive Elemente 4, 104 auf der beweglichen Struktur 3 angeordnet. Die zwei magnetsensitiven Elemente 4, 104 können sich nicht relativ zu der beweglichen Struktur 3 bewegen.

Der Sensor 1 ist dazu ausgestaltet, eine relative Position der beweglichen Struktur 3 zu der starren Struktur 2 in xy-Ebene zu bestimmen.

Figur 4 zeigt ein viertes Ausführungsbeispiel des Sensors 1, wobei in der linken Abbildung ein Querschnitt durch die xz-Ebene und in der rechten Abbildung ein Querschnitt durch die xy-Ebene dargestellt ist.

Der in Figur 4 dargestellte Sensor 1 unterscheidet sich von dem in Figur 3 dargestellten Sensor 1 dadurch, dass die magnetsensitiven Elemente 4, 104 in einem unausgelenkten Zustand der beweglichen Struktur 3 außerhalb der Ebene angeordnet sind, die durch die vier Magneten 5, 105, 205, 305 aufgespannt wird. Die Bewegliche Struktur 3 weist eine Erhöhung 10 auf, auf der die beiden magnetsensitiven Elemente 4, 104 angeordnet sind. Der Sensor 1 ermöglicht eine Bestimmung der x-, y- und z-Koordinate der Position der beweglichen Struktur 3 relativ zu der starren Struktur 2. Eine eindeutige Bestimmung der z-Koordinate ist möglich, sofern die bewegliche Struktur 3 sich nicht so weit in die negative z-Richtung bewegt, dass die beiden magnetsensitiven Elemente 4, 104 unterhalb der von den vier Magneten 5, 105, 205, 305 aufgespannten Ebene angeordnet sind.

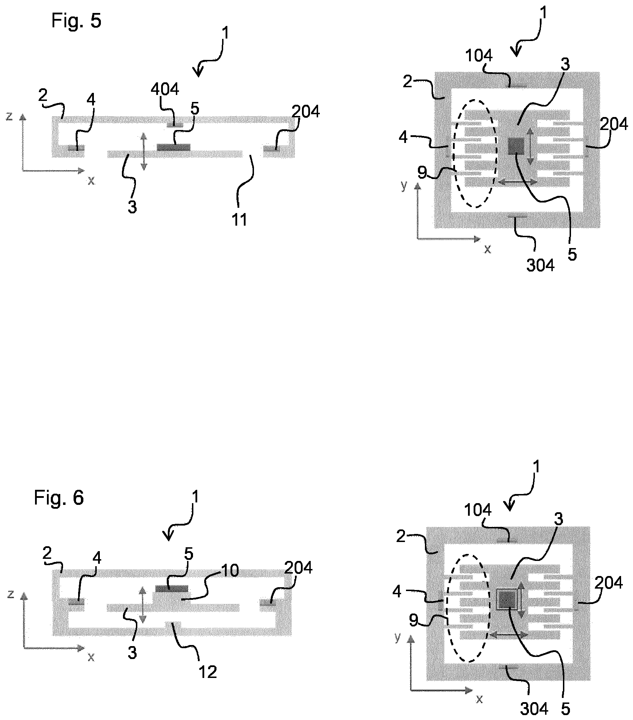

Figur 5 zeigt ein fünftes Ausführungsbeispiel des Sensors 1. Das fünfte Ausführungsbeispiel unterscheidet sich von dem in Figur 1 gezeigten ersten Ausführungsbeispiel dadurch, dass ein weiteres magnetsensitives Element 404 oberhalb des Magneten 5 angeordnet ist. Das weitere magnetsensitive Element 404 ist dementsprechend außerhalb der Ebene angeordnet, in der das erste bis vierte magnetsensitive Element 4, 104, 204, 304 angeordnet sind. Dementsprechend ermöglicht es der Sensor 1, die x-, y- und z-Koordinate der Position des beweglichen Struktur 3 eindeutig zu bestimmen. Insbesondere ist eine eindeutige Bestimmung der z-Koordinate ohne Einschränkungen möglich. Die starre Struktur 2 ist als ein geöffneter Rahmen ausgebildet, der die bewegliche Struktur 3 an den Seiten und der Oberseite umschließt und der auf seiner Unterseite eine Öffnung 11 aufweist.

Figur 6 zeigt ein sechstes Ausführungsbeispiel des Sensors 1. Bei dem sechsten Ausführungsbeispiel sind vier magnetsensitive Elemente 4, 104, 204, 304 in einer Ebene angeordnet und ferner ist ein Magnet 5 außerhalb der Ebene auf der beweglichen Struktur 3 befestigt, wobei der Magnet 5 sich außerhalb der Ebene befindet, wenn die bewegliche Struktur 3 in einem unausgelenkten Zustand ist. Ferner weist der Sensor 1 einen Anschlag 12 auf, der dazu ausgestaltet ist, die Bewegungsmöglichkeiten des Magneten 5 derart zu begrenzen, dass der Magnet 5 sich stets auf einer Oberseite der Ebene oder in der Ebene befindet.

Die starre Struktur 2 ist als Rahmen ausgebildet, der die bewegliche Struktur 3 allseitig umgibt. Die starre Struktur 2 ist also ein geschlossener dreidimensionaler Rahmen, der eine Kavität einschließt, wobei die bewegliche Struktur 3 innerhalb der Kavität angeordnet ist.

Weitere Ausführungsformen des Sensors 1 sind denkbar. Beispielsweise können auch bei dem fünften und sechsten Ausführungsbeispiel die magnetsensitiven Elemente 4, 104, 204, 304, 404 auf der beweglichen Struktur 3 und die Magneten 5, 105 auf der starren Struktur 2 angeordnet werden.

Bei den in den Figuren gezeigten Ausführungsbeispielen handelt es sich bei der beweglichen Struktur 3 stets um eine Membran. Die bewegliche Struktur 3 kann jedoch auch als seismische Masse ausgebildet sein.

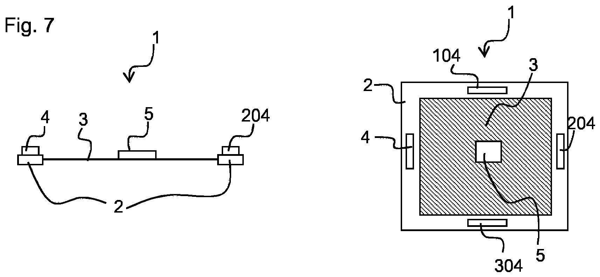

Figur 7 zeigt ein siebtes Ausführungsbeispiel eines Sensors. 1. Bei dem Sensor 1 handelt es sich um einen Sensor zur Messung eines Drucks. Auch bei diesem Sensor 1 ist die bewegliche Struktur 3 eine Membran. Ferner ist die starre Struktur 2 ein Rahmen. Die Randbereiche der beweglichen Struktur 3 sind derart an der starren Struktur 2 befestigt, dass sie sich nicht in z-Richtung bewegen können, wobei die z-Richtung definiert ist als Richtung der Flächennormalen der beweglichen Struktur 3. Ein innerer Bereich der beweglichen Struktur 3, der sich an den Randbereich anschließt, kann sich in x-Richtung relativ zu der starren Struktur 2 bewegen.

### Bezugszeichenliste

- 1: Sensor
- 2: starre Struktur
- 3: bewegliche Struktur
- 4: erste magnetsensitive Elemente
- 5: Magnet
- 9: Kammstruktur
- 10: Erhöhung
- 11: Öffnung
- 12: Anschlag
- 104: zweite magnetsensitive Elemente
- 105: Magnet
- 204: dritte magnetsensitive Elemente
- 205: Magnet
- 304: vierte magnetsensitive Elemente
- 305: Magnet
- 404: weitere magnetsensitive Elemente

## Patentansprüche

1. Sensoranordnung aufweisend
- einen ersten Sensor (1), der eine Beschleunigung mit drei Freiheitsgraden bestimmt,
- einen zweiten Sensor, der eine Drehrate mit drei Freiheitsgraden bestimmt,
- einen dritten Sensor, der eine Ausrichtung auf dem Erdmagnetfeld mit drei Freiheitsgraden bestimmt, und
- einen vierten Sensor, der eine Höhe mittels einer Druckmessung bestimmt,
wobei der erste Sensor (1), der zweite Sensor und der vierte Sensor jeweils ein magnetsensitives Element (4) und einen Magneten (5) aufweisen, von denen ein Element auf einer beweglichen Struktur (3) und das andere auf einer starren Struktur (2) angeordnet ist,
wobei eine Relativposition der beweglichen Struktur (3) zu der zugehörigen starren Struktur (2) jeweils durch eine Bestimmung des Magnetfeldes an der Position des zugehörigen magnetsensitiven Elements (4) bestimmt wird, und
wobei der dritte Sensor ein magnetsensitives Element aufweist und das Erdmagnetfeld mittels des magnetsensitiven Elements bestimmt wird.

2. Sensoranordnung gemäß Anspruch 1,
die eine Ausleseelektronik aufweist, die für alle Sensoren das gleiche Signalwandlungsprinzip verwendet.

3. Sensoranordnung gemäß einem der vorherigen Ansprüche,
wobei es sich bei dem magnetsensitiven Element um ein Hall-Element handelt, das auf Basis des Hall-Effektes die Feldstärke eines Magnetfeldes misst, oder
wobei das magnetsensitive Element das Magnetfeld mit Hilfe des magnetoresistiven Effekts bestimmt.

## Claims

1. Sensor arrangement having
- a first sensor (1) which determines an acceleration with three degrees of freedom,
- a second sensor which determines a rate of rotation with three degrees of freedom,
- a third sensor which determines an orientation to the Earth's magnetic field with three degrees of freedom, and
- a fourth sensor which determines a height by means of a pressure measurement,
wherein the first sensor (1), the second sensor and the fourth sensor each have a magnetically sensitive element (4) and a magnet (5), one element of which is arranged on a moving structure (3) and the other of which is arranged on a fixed structure (2),
wherein a relative position of the moving structure (3) to the associated fixed structure (2) is in each case determined by determining the magnetic field at the position of the associated magnetically sensitive element (4), and
wherein the third sensor has a magnetically sensitive element, and the Earth's magnetic field is determined by means of the magnetically sensitive element.

2. Sensor arrangement according to Claim 1,
which has a reading electronics system which uses the same signal conversion principle for all sensors.

3. Sensor arrangement according to either of the preceding claims,
wherein the magnetically sensitive element is a Hall element which measures the field strength of a magnetic field on the basis of the Hall effect, or
wherein the magnetically sensitive element determines the magnetic field with the aid of the magnetoresistive effect.

## Revendications

1. Ensemble capteur comportant
- un premier capteur (1) qui détermine une accélération avec trois degrés de liberté,
- un deuxième capteur qui détermine une vitesse de rotation avec trois degrés de liberté,
- un troisième capteur qui détermine une orientation le long du champ magnétique terrestre avec trois degrés de liberté, et
- un quatrième capteur qui détermine une hauteur au moyen d'une mesure de pression,
dans lequel le premier capteur (1), le deuxième capteur et le quatrième capteur comportent respectivement un élément magnétosensible (4) et un aimant (5), parmi lesquels un élément est disposé sur une structure mobile (3) et l'autre est disposé sur une structure rigide (2), dans lequel une position relative de la structure mobile (3) par rapport à la structure rigide (2) associée est respectivement déterminée en déterminant le champ magnétique à la position de l'élément magnétosensible (4) associé, et
dans lequel le troisième capteur comprend un élément magnétosensible et le champ magnétique terrestre est déterminé au moyen de l'élément magnétosensible.

2. Ensemble capteur selon la revendication 1, qui possède une électronique de lecture utilisant le même principe de conversion de signal pour tous les capteurs.

3. Ensemble capteur selon l'une des revendications précédentes, dans lequel l'élément magnétosensible est un élément Hall qui mesure l'intensité de champ d'un champ magnétique sur la base de l'effet Hall, ou dans lequel l'élément magnétosensible détermine le champ magnétique au moyen de l'effet magnétorésistif.
